# EUROPÄISCHE PATENTANMELDUNG

(11) **EP 3 200 225 A2**
(43) Veröffentlichungstag der Anmeldung: **02.08.2017**
(21) Anmeldenummer: 17153964.6
(22) Anmeldetag: 31.01.2017
(51) Int. Cl.: H01L 23/373, H01L 23/40, H01L 23/473, H01L 25/07

(54) **ELEKTRONIKMODUL MIT EINER LEISTUNGSHALBLEITERANORDNUNG**

(30) Priorität: 01.02.2016 DE 202016100481 U
(71) Anmelder: Gebr. Bode GmbH & Co. KG, 34123 Kassel (DE)
(72) Erfinder: Blumenstein, Felix, 37235 Hess. Lichtenau (DE)
(74) Vertreter: Patentanwälte Bauer Vorberg Kayser

(57) **Zusammenfassung**

Die Erfindung betrifft ein Elektronikmodul mit einer Leistungshalbleiteranordnung (1), welche Leistungshalbleiteranordnung (1) zum Betrieb an einer elektrischen Versorgungsleitung (2), welche mit einer Betriebs-Hochspannung gespeist wird, einer Netzinfrastruktur (3) zum leitungsgebundenen Betrieb von Landfahrzeugen (4) eingerichtet ist. Das Elektronikmodul weist einen Kühlkörper (7) zur Aufnahme von beim Betrieb der Leistungshalbleiteranordnung (1) entstehender Wärme durch Wärmeleitung auf. Der Kühlkörper (7) ist dazu eingerichtet, die aufgenommene Wärme überwiegend durch Wärmeströmung an Fluid abzugeben. Das erfindungsgemäße Elektronikmodul ist dadurch gekennzeichnet, dass der Kühlkörper 7 aus einem Keramikmaterial besteht. Die Erfindung betrifft ebenso eine entsprechende Umrichtervorrichtung.

## Beschreibung

Die Erfindung betrifft ein Elektronikmodul mit einer Leistungshalbleiteranordnung mit den Merkmalen des Oberbegriffs von Anspruch 1 sowie eine Umrichtervorrichtung mit den Merkmalen des Oberbegriffs von Anspruch 14.

Leistungshalbleiter und insbesondere Elektronikmodule mit solchen Leistungshalbleitern werden in vielfältigen technischen Bereichen eingesetzt. Einen wichtigen Anwendungsbereich bilden elektrisch angetriebene und leitungsgebundene Fahrzeuge, zu denen etwa viele Schienenfahrzeuge und Oberleitungsbusse zählen. Die zur Versorgung dieser Fahrzeuge eingesetzte Versorgungsleitung wird, je nach vorliegendem Bahnstromsystem, regelmäßig mit einer Betriebsspannung im Hochspannungsbereich betrieben, also mit einer Betriebsspannung, welche einen Effektivwert von mindestens 1000 Volt (1 kV) aufweist. Bekannt sind insbesondere Betriebsspannungen mit einer Gleichspannung von 1500 Volt oder 3000 Volt. Hinsichtlich solcher Versorgungsnetze ist die DIN EN 50163 einschlägig.

Neben dem Antrieb des Fahrzeugs gibt es an und in dem Fahrzeug regelmäßig noch weitere Verbraucher wie etwa Klimaanlagen, Kommunikations- oder Steuervorrichtungen und auch Unterhaltungselektronik, welche mit einer Betriebsspannung im Niederspannungsbereich betrieben werden. Zur Umwandlung der Betriebs-Hochspannung, welche von der elektrischen Versorgungsleitung empfangen wird, in eine entsprechend niedrigere Betriebs-Niederspannung werden regelmäßig sogenannte Hilfsbetriebeumrichter eingesetzt, welche wiederum Leistungshalbleiter wie insbesondere Bipolartransistoren mit isolierter Gate-Elektrode (insulated-gate bipolar transistor), auch als IGBTs bezeichnet, oder Feldeffekttransistoren (FET) als wesentliche Bestandteile aufweisen. Ein solcher IGBT, von welchem die vorliegende Erfindung als nächstkommend ausgeht, wird in der EP 1 364 402 B1 beschrieben.

Der spezielle Bereich der Bahnanwendungen bringt es mit sich, dass besonders strenge Normen für die mit der Versorgungsleitung elektrisch (galvanisch) verbundenen Bauteile und damit auch für die hier gegenständlichen Elektronikmodule eingehalten werden müssen. In diesem Zusammenhang sind die EN 50124 sowie die EN 60077 zu nennen. So müssen diese Elektronikmodule eine Isolationsspannung erreichen, welche im Verhältnis zu der Sperrspannung z. B. eines IGBT des Elektronikmoduls wesentlich höher ist als diejenige, welche etwa für Anwendungen eines ansonsten identischen IGBTs im industriellen Automatisierungsbereich gefordert werden.

Gegenüber anderen Anwendungsfeldern von IGBTs ist dieser auf diese Weise strenger normierte Bereich von geringeren Stückzahlen und größerer Individualisierung in der Konstruktion und Konfektion gekennzeichnet. Daher besteht ein wesentlich kleineres und deswegen häufig unzureichendes Angebot an IGBTs und entsprechenden Halbleitermodulen, welche bereits von Hause aus eine normkonforme Kombination aus Sperr- und Isolationsspannung aufweisen.

Häufig wird daher auf Standard-IGBTs zurückgegriffen, wobei diese dann entweder mit der erforderlichen Isolationsspannung ausgewählt werden oder nachträgliche Maßnahmen zur Erhöhung der Isolationsspannung durchgeführt werden. Diese nachträglichen Maßnahmen bestehen regelmäßig darin, eine zusätzliche Isolationsschicht zwischen dem Halbleitermodul und einem Kühlkörper anzuordnen. Da hierdurch auch der thermische Widerstand vergrößert wird, beschränkt dieser Umstand die Leistungsfähigkeit der Anordnung im Vergleich ohne diese zusätzliche Isolierung. Im Ergebnis ist dieser Ansatz außerdem spürbar teurer. Die vorgenannte Verwendung von Halbleitermodulen mit ausreichender Isolationsspannung hingegen führt dazu, dass die Sperrspannung im Vergleich zu der Betriebsspannung überdimensioniert ist, was wiederum zu einer Verschlechterung des elektrischen Verhaltens führt. Außerdem sind Halbleiter mit sehr hoher Sperrspannung teurer.

Ausgehend von dem Stand der Technik besteht die Aufgabe der Erfindung darin, einen Ansatz bereitzustellen, mit dem Standardmodule mit Leistungshalbleitern und gegenüber der Sperrspannung erhöhter Isolationsspannung erhalten werden können, welche gegenüber den bekannten Lösungen sowohl kostengünstiger in der Herstellung als auch in technischer Hinsicht verbessert sind.

Bezogen auf ein Elektronikmodul mit einer Leistungshalbleiteranordnung mit den Merkmalen des Oberbegriffs von Anspruch 1 wird die Aufgabe durch die Merkmale des kennzeichnenden Teils von Anspruch 1 gelöst. Bezogen auf eine Umrichtervorrichtung mit den Merkmalen des Oberbegriffs von Anspruch 14 wird die Aufgabe durch die Merkmale des kennzeichnenden Teils von Anspruch 14 gelöst.

Wesentlich für die Erfindung ist die Erkenntnis, dass eine Erhöhung der Isolationsspannung bei gleichzeitig niedrigem thermischen Widerstand und mit akzeptablen Kosten dadurch erreicht werden kann, dass anstelle eines Kühlkörpers aus Metall ein keramischer Kühlkörper - also ein Kühlkörper aus einem Keramikmaterial - eingesetzt wird. Da dieser - im Gegensatz zum Kühlkörper aus Metall - bereits durch sein Material elektrisch isolierend ist, entfällt die Notwendigkeit einer isolierenden Zwischenschicht vor dem letztendlichen Kühlkörper. Gleichzeitig weist ein solcher keramischer Kühlkörper auch geeignete thermische Eigenschaften auf. Dieser Gedanke erlaubt es auch, an ein Standardmodul mit einer Leistungshalbleiteranordnung nachträglich einen solchen keramischen Kühlkörper anzuordnen. Auf diese Weise kann ein Elektronikmodul mit einer Isolationsspannung erhalten werden, welche im Verhältnis zu der Sperrspannung verhältnismäßig größer ist, als dies bei Standardmodulen üblicherweise der Fall ist. Somit können Standardmodule auch leichter in Umgebungen eingesetzt werden, wo diese besonderen Anforderungen an das Verhältnis von Isolations- zu Sperrspannung gestellt werden.

Grundsätzlich gibt es eine große Vielzahl von bekannten Halbleitermodulen, bei denen verschiedene Schichten aus Keramik und Metall zwischen dem Leistungshalbleiter an sich und einem Kühlkörper angeordnet sind. Als Kühlkörper im engeren Sinne, welcher also vorschlagsgemäß aus einem Keramikmaterial besteht, wird hier und nachfolgend derjenige Körper verstanden, welcher das letzte Glied bei der Wärmeleitung (Konduktion) von dem Halbleiter ausgehend bildet und von welchem daher die Wärme überwiegend oder im Wesentlichen ausschließlich durch Wärmeströmung (Konvektion) an ein ggf. bewegtes Fluid abgegeben wird. Dieser Kühlkörper, welcher also eine Wärmesenke bzgl. der Konduktion bildet, ist also vorschlagsgemäß aus einem Keramikmaterial bestehend. Das vorschlagsgemäße Erfordernis ist also nicht durch eine Zwischenschicht für die Konduktion aus Keramik erfüllt, da diese die aufgenommene Wärme nicht überwiegend durch Konvektion abgibt, sondern vielmehr durch Konduktion entweder den Kühlkörper im engeren Sinne oder an eine weitere Zwischenschicht.

Bei dem Fluid kann es sich grundsätzlich um eine Flüssigkeit oder um ein Gas handeln, wobei die bevorzugte Ausgestaltung des Unteranspruchs 2 einen Kühlkörper beschreibt, der durch die Durchführung eines Kühlfluids besonders wirksam Wärme abführen kann.

Ein Elektronikmodul wie es für den Vorschlag gegenständlich ist weist regelmäßig eine Grundplattenanordnung auf, welche jedenfalls als Träger für die Leistungshalbleiter dient. Die Unteransprüche 3 bis 6 betreffen verschiedene bevorzugte Ausgestaltungen einer solchen Grundplattenanordnung, welche unterschiedliche Schichten aufweisen kann.

Die Unteransprüche 7 bis 9 betreffen bevorzugte Möglichkeiten, wie ein Elektronikmodul, welches ein Gehäuse aufweist, mit dem Kühlkörper verbunden werden kann. Die hier beschriebenen Möglichkeiten haben sich speziell bei einem keramischen Kühlkörper bedingt durch die gegenüber einem Metallkörper unterschiedlichen Bearbeitungsmöglichkeiten als vorteilhaft erwiesen.

Bei den Unteransprüchen 10 und 11 wiederum geht es um eine bevorzugte Variante, bei der an dem Kühlkörper beidseitig jeweils ein Leistungshalbleiter angeordnet ist. Dieser Ansatz erlaubt eine Befestigung der Leistungshalbleiter an dem Kühlkörper, welche Art der Befestigung ohne eine potenziell schädliche Bearbeitung des keramischen Kühlkörpers auskommt.

Weitere vorteilhafte und bevorzugte Ausgestaltungen ergeben sich aus der nachfolgenden Beschreibung mit Bezug auf die Figuren. In der lediglich ein Ausführungsbeispiel wiedergebenden Zeichnung zeigt
- Fig. 1: schematisch ein elektrisches Schienenfahrzeug mit einem vorschlagsgemäßen Elektronikmodul in einem Hilfsbetriebeumrichter,
- Fig. 2: schematisch das vorschlagsgemäße Elektronikmodul aus dem Hilfsbetriebeumrichter in der Fig. 1 in einer seitlichen Schnittansicht und
- Fig. 3: das vorschlagsgemäße Elektronikmodul der Fig. 2 in einer Perspektivansicht.

Das vorschlagsgemäße Elektronikmodul weist eine Leistungshalbleiteranordnung 1 auf, welche zum Betrieb an einer elektrischen Versorgungsleitung 2 einer Netzinfrastruktur 3 zum leitungsgebundenen Betrieb von Landfahrzeugen 4 eingerichtet ist. Vorschlagsgemäß wird dabei die Versorgungsleitung 2 mit einer Betriebs-Hochspannung gespeist. Es handelt sich also um eine Betriebsspannung der Versorgungsleitung 2, welche einen Effektivwert von größer als 1 kV aufweist. Bei dieser Betriebs-Hochspannung kann es sich sowohl um Gleichspannung als auch um Wechselspannung handeln. Im vorliegenden Ausführungsbeispiel handelt es sich bei der Betriebsspannung um eine Gleichspannung von 1500 Volt. Bei einer sinusförmigen Wechselspannung ist der Effektivwert um den Faktor √2 kleiner als der Spitzenwert der Spannung.

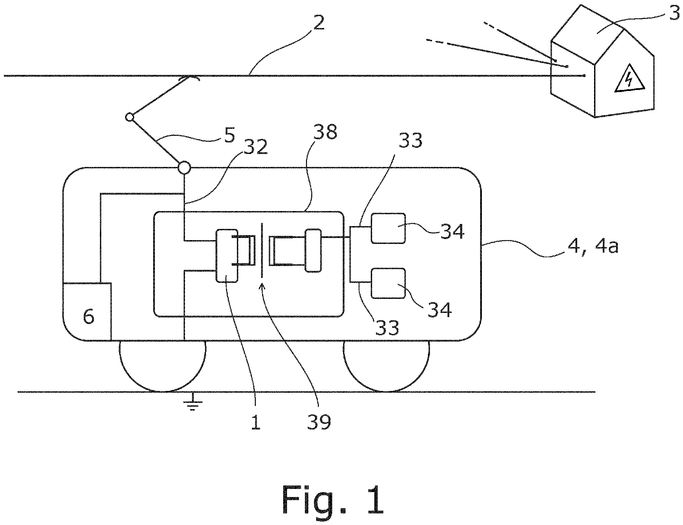

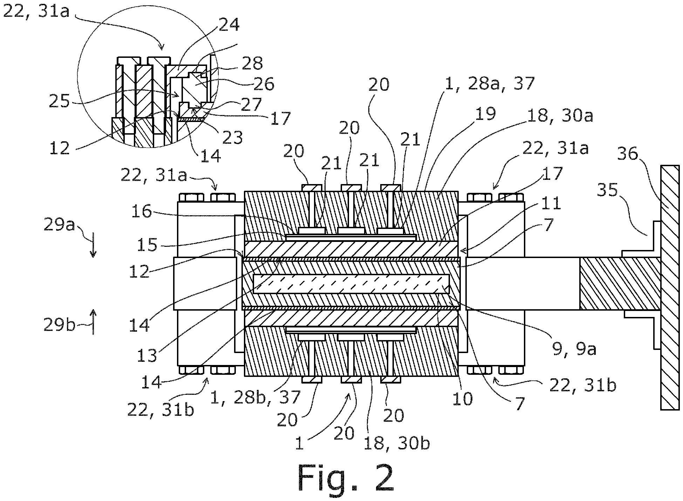

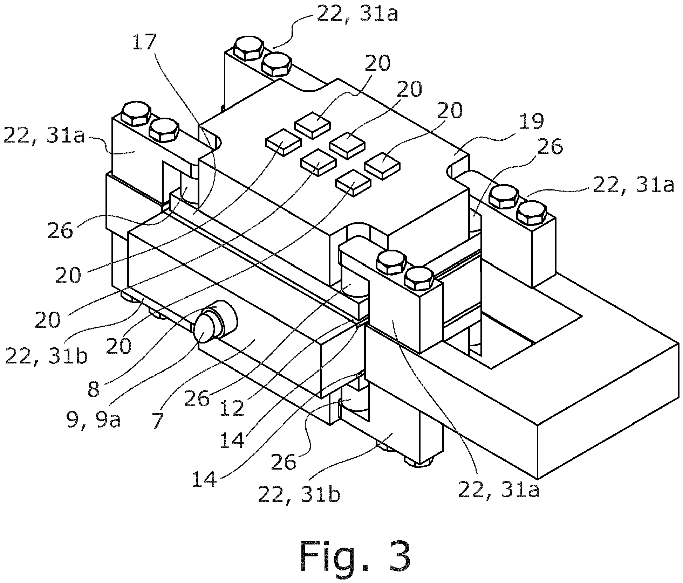

Die Fig. 1 zeigt ein elektrisch angetriebenes Schienenfahrzeug 4a als ein solches Landfahrzeug 4, welches über einen Stromabnehmer 5 mit der Versorgungsleitung 2 elektrisch verbunden ist. Die Versorgungsleitung 2 ist Bestandteil einer Netzinfrastruktur 3 zum Betrieb einer Vielzahl solcher Schienenfahrzeuge 4a. Es kann sich dabei um ein Stromnetz für Straßenbahnen, Eisenbahnen, U-Bahnen o. dgl. handeln. Bei dem Landfahrzeug 4 kann es sich auch um einen - hier nicht gezeigten - Oberleitungsbus handeln, wobei die Netzinfrastruktur 3 dann ein Stromnetz für Oberleitungsbusse ist. Gemäß der Darstellung der Fig. 1 ist das Elektronikmodul in dem Schienenfahrzeug 4a angeordnet. Es kann sich bei dem vorschlagsgemäßen Elektronikmodul aber auch um eine Vorrichtung handeln, welche zwar elektrisch mit der Versorgungsleitung 2 der Netzinfrastruktur 3 verbunden ist, welche aber stationär ist und folglich nicht auf einem Fahrzeug angeordnet ist. Insbesondere wird ein elektrischer Antrieb 6 des Landfahrzeugs 4 durch die Versorgungsleitung 2 mit elektrischer Energie versorgt. Die Leistungshalbleiteranordnung 1 kann vorschlagsgemäß eine beliebige Zahl und beliebige Arten von Halbleiterbauelementen umfassen, welche Halbleiterbauelemente für Ströme von mehr als 1 Ampere und für Spannungen von mehr als 24 Volt ausgelegt sind. Die Einzelheiten des Aufbaus des vorschlagsgemäßen Elektronikmoduls gehen aus der Fig. 2 und der Fig. 3 hervor.

Vorschlagsgemäß weist das Elektronikmodul einen Kühlkörper 7 zur Aufnahme von beim Betrieb der Leistungshalbleiteranordnung 1 entstehender Wärme durch Wärmeleitung auf. Diese Wärme wird also von der Leistungshalbleiteranordnung 1 zu dem Kühlkörper 7 zumindest teilweise und vorzugsweise überwiegend durch Konduktion übertragen. Entsprechend berührt der Kühlkörper 7 die Leistungshalbleiteranordnung 1 entweder direkt oder - bevorzugt und wie überwiegend der Fall - indirekt, also mit einer oder mehr ebenfalls in Berührung stehender Zwischenschichten. Dies wird untenstehend noch genauer beschrieben.

Vorschlagsgemäß ist der Kühlkörper 7 dazu eingerichtet, die aufgenommene Wärme überwiegend durch Wärmeströmung an Fluid abzugeben. Ein solches Fluid kann eine beliebige Flüssigkeit oder ein beliebiges Gas sein, z. B. die den Kühlkörper 7 umgebende Luft. Entsprechend steht der Kühlkörper 7 an zumindest Teilen seiner Oberfläche mit dem Fluid in Berührung. Die überwiegende Abgabe an Fluid kann einerseits dadurch definiert werden, dass mehr als die Hälfte der aufgenommenen Wärme - vorzugsweise im Wesentlichen die gesamte aufgenommene Wärme - an das Fluid abgegeben. Andererseits kann die überwiegende Abgabe an Fluid auch dadurch definiert werden, dass das Flächenmaß der Oberfläche des Kühlkörpers 7, welche mit dem Fluid in Berührung steht, mindestens doppelt so groß ist wie eine etwaig vorhandene Berührungsfläche mit einem festen Körper, an den über Konduktion Wärme abgegeben werden könnte. Dabei kommen auch Flächen in Betracht, welche einen Hohlraum im Innern des Kühlkörpers 7 begrenzen und definieren (sofern über diese eine Wärmeabgabe an ein Fluid wie beschrieben erfolgt). Solche Flächen sind beim vorliegenden Ausführungsbeispiel gegeben, wie untenstehend noch beschrieben wird. Hingegen kommen Berührungsflächen nicht in Betracht, über die Wärme aufgenommen wird, wozu insbesondere diejenigen Berührungsflächen zählen, über welche der Kühlkörper 7 Wärme von der Leistungshalbleiteranordnung 1 aufnimmt.

Das vorschlagsgemäße Elektronikmodul ist dadurch gekennzeichnet, dass der Kühlkörper 7 aus einem Keramikmaterial besteht. Das Keramikmaterial ist anorganisch, nichtmetallisch und polykristallin. Das Keramikmaterial wird als Ergebnis eines Sinterns erhalten. Als bevorzugtes solches Keramikmaterial kommen beispielsweise Aluminiumoxid und Aluminiumnitrid in Frage.

Bevorzugt ist, dass das Elektronikmodul eine Zuführvorrichtung 8 zum Zuführen eines Kühlfluids 9 an den Kühlkörper 7 und zum Abführen des Kühlfluids 9 von dem Kühlkörper 7 aufweist. Diese Zuführvorrichtung 8 ist in der Fig. 3 erkennbar. Bei dem Kühlfluid 9 handelt es sich vorzugsweise um eine Kühlflüssigkeit 9a, wie z. B. Wasser. Bevorzugt ist ebenso, dass das Elektronikmodul eine Leitungsanordnung 10 zum Durchleiten des Kühlfluids 9 durch den Kühlkörper 7 aufweist, sodass von dem Kühlkörper 7 aufgenommene Wärme an das zugeführte Kühlfluid 9 abgegeben und das somit erwärmte Kühlfluid 9 von der Zuführvorrichtung 8 abgeführt wird. Bei einer solchen Leitungsanordnung 10 kann es sich, wie in der Fig. 2 dargestellt, um eine Kanalanordnung oder ähnliche Hohlräume innerhalb des Kühlkörpers 7 handeln. Entsprechend tragen die entsprechenden inneren Oberflächen des Kühlkörpers 7 zu dem obigen Flächenmaß bei. Die Wärmeabgabe an das Kühlfluid 9 wird also dadurch noch verstärkt, dass ein Stofftransport des erwärmten Kühlfluids 9 durch die Zuführvorrichtung 8 stattfindet. Dabei kann das Elektronikmodul auch eine - hier nicht gezeigte - Vorrichtung zum Bewegen des Kühlfluids 9 durch die Zuführvorrichtung 8, etwa eine Kühlfluidpumpe, aufweisen. Die Zuführvorrichtung 8 kann das abgeführte Kühlfluid 9 dann einer Senke zur Abgabe der aufgenommenen Wärme zuführen, wonach das Kühlfluid 9 dann in einem Kreislauf wieder dem Kühlkörper 7 zugeführt wird.

Ebenso ist es bevorzugt und wie in der Fig. 2 dargestellt der Fall, dass das Elektronikmodul eine zwischen der Leistungshalbleiteranordnung 1 und dem Kühlkörper 7 angeordnete Grundplattenanordnung 11 aufweist, sodass die beim Betrieb der Leistungshalbleiteranordnung 1 entstehende Wärme durch Wärmeleitung mittels der Grundplattenanordnung 11 an den Kühlkörper 7 übertragen wird. Eine solche Grundplattenanordnung 11 kann auf verschiedene Arten ausgestaltet sein, wie nachfolgend beschrieben wird.

Gemäß einer bevorzugten Ausführungsform und wie in der Fig. 2 erkennbar ist vorgesehen, dass eine Deckfläche 12 des Kühlkörpers 7 eine zu der Deckfläche 12 im Wesentlichen parallele und der Deckfläche 12 zugewandte Grundfläche 13 der Grundplattenanordnung 11 im Wesentlichen vollständig abdeckt. Ein solches Abdecken kann auch durch einen nur indirekten Kontakt, also mit Zwischenschichten, zwischen der Deckfläche 12 und der Grundfläche 13 vorliegen. Eine solche im Wesentlichen vollständige Abdeckung gewährleistet, dass möglichst viel der Wärme von dem Kühlkörper 7 aufgenommen wird. Bei dieser Deckfläche 12 kann es sich um eine im Prinzip beliebige Außenfläche - abgesehen von der Berührung mit der Grundplattenanordnung 11 - des Kühlkörpers 7 handeln, ebenso wie es sich bei der Grundfläche 13 ebenfalls um eine ansonsten beliebige Außenfläche der Grundplattenanordnung 12 handeln kann.

Weiter ist es bevorzugt, dass die Deckfläche 12 die Grundfläche 13 im Wesentlichen entlang des gesamten Umrisses der Grundfläche 13 überragt. Auch dies ist in den Fig. 2 und 3 zu erkennen. Auf diese Weise wird die Ausdehnung des Kühlkörpers 7 und damit die Oberfläche zur Abgabe der aufgenommenen Wärme nicht durch die Dimensionen der Grundplattenanordnung 11 begrenzt. Auf der Deckfläche 12 kann eine vorzugsweise metallische Leiterschichtfläche 14 angeordnet sein, wobei vorzugsweise die Leiterschichtfläche 14 die Grundfläche 13 im Wesentlichen vollständig abdeckt. Die Leiterschichtfläche 14 kann dabei auch deutlich größer als die Grundfläche 13 sein. Auf diese Weise wird gewährleistet, dass unmittelbar an dem der Grundfläche 13 entsprechenden Abschnitt der Deckfläche 12 ein gleichmäßiges elektrisches Potenzial vorliegt, sodass das elektrische Feld in dem isolierenden Kühlkörper 7 ebenfalls - bis auf durch die Geometrie bedingte Eigenschaften - im Wesentlichen gleichmäßig ist. Feldspitzen, welche sich durch Knoten mit einem undefinierten Potenzial ergeben können, werden somit vermieden. Diese metallische Fläche kann bei Bedarf an ein definiertes Potential elektrisch angebunden werden.

Bezogen auf die Grundplattenanordnung 11 ist gemäß dem Ausführungsbeispiel in der Fig. 2 bevorzugt, dass sie eine ebene Trägerplatte 15 aufweist, auf welcher die Leistungshalbleiteranordnung 1 befestigt ist, und dass das Elektronikmodul eine auf die Trägerplatte 15 aufgetragene Leiterbahnanordnung 16 zur elektrischen Verbindung der Leistungshalbleiteranordnung 11 aufweist. Die Trägerplatte 15 dient also als Substrat. Insoweit kann es sich bei der Trägerplatte 15 also um eine im Prinzip bekannte Leiterplatte handeln. Hier ist es weiter bevorzugt, dass die Trägerplatte 15 eine Keramikplatte ist und die Leiterbahnanordnung 16 Kupferleiterbahnen umfasst. Als Keramikplatte kann also die Trägerplatte 15 auch zur internen Isolierung des Elektronikmoduls dienen.

Es kann sein - und ist sogar regelmäßig der Fall - dass auch dickere metallische Schichten von der Grundplattenanordnung 11 umfasst sind. Es sind zwar auch Module bekannt, bei denen eine Leistungshalbleiteranordnung 11 lediglich auf einer insbesondere keramischen Leiterplatte als Trägerplatte 15 angeordnet ist, ohne dass von vornherein eine darunterliegende und insbesondere metallische Bodenplatte vorgesehen wäre. Bevorzugt ist jedoch, dass die Grundplattenanordnung 11 eine metallische und ebene Bodenplatte 17 aufweist, welche insbesondere gegenüber der Leistungshalbleiteranordnung 11 elektrisch isoliert ist. Diese elektrische Isolierung gegenüber der Leistungshalbleiteranordnung 11 kann sich auf einige Pole 21 der Leistungshalbleiteranordnung 11 beschränken und betrifft dann insbesondere keine Pole der Leistungshalbleiteranordnung 11, welche mit einem Massepotenzial verbunden sind.

Die Variante mit einer solchen Bodenplatte 17 entspricht auch dem insbesondere in den Fig. 2 und 3 gezeigten Ausführungsbeispiel. Bevorzugt umfasst die Bodenplatte 17 Kupfer oder besteht im Wesentlichen aus Kupfer. Bevorzugt deckt diese Bodenplatte 17 die Trägerplatte 15 im Wesentlichen vollständig ab. Im Hinblick auf die obige Leiterschichtfläche 14 ist vorzugsweise die Bodenplatte 17 mit der Leiterschichtfläche 14 elektrisch verbunden, sodass die Leiterschichtfläche 14 gegenüber der Bodenplatte 17 auf einem im Wesentlichen identischen elektrischen Potenzial ist. Auch dies dient dazu, undefinierte Potenzialverteilungen und damit einhergehende Spitzen in der elektrischen Feldstärke in dem Kühlkörper 7 oder im Halbleitermodul zu vermeiden.

Die oben beschriebene Grundplattenanordnung 11 bildet - wenn vorhanden - die Unterseite des Elektronikmoduls. Bezüglich der anderen Seiten des Elektronikmoduls ist bevorzugt vorgesehen, dass das Elektronikmodul ein Gehäuse 18 zur Aufnahme der Leistungshalbleiteranordnung 11 aufweist. Dieses Gehäuse 18 kann - wie in dem vorliegenden Ausführungsbeispiel der Fig. 2 und 3 - auch die obige Grundplattenanordnung 11 umfassen, sodass auch die Grundplattenanordnung 11 der Aufnahme der Leistungshalbleiteranordnung 11 dient. Dieses Gehäuse 18 kann - wie aus der Fig. 2 und 3 hervorgeht - einen nichtleitenden Gehäuseabschnitt 19 aufweisen. Ebenso kann das Elektronikmodul eine Kontaktanordnung 20 an dem nichtleitenden Gehäuseabschnitt 19 zur elektrischen Verbindung mit Polen 21 der Leistungshalbleiteranordnung 1 aufweisen. Somit bildet die Kontaktanordnung 20 die äußeren elektrischen Anschlüsse für die Kontaktierung der Leistungshalbleiteranordnung 1. Diese Kontaktanordnung 20 ist insbesondere gegenüber der Bodenplatte 17 elektrisch isoliert.

Bezüglich der Befestigung an dem Kühlkörper 7 ist bevorzugt vorgesehen, dass das Elektronikmodul eine Fixieranordnung 22 zum Anpressen des Gehäuses 18 an den Kühlkörper 7 aufweist. Eine solche Fixieranordnung 22 ist in den Fig. 2 und 3 dargestellt. Speziell kann die Fixieranordnung 22 eine Vielzahl von Druckflächen 23 zum Anpressen des Gehäuses 18 an den Kühlkörper 7 aufweisen, welche Druckflächen 23 jeweils beabstandet voneinander mit dem Gehäuse 18 im Eingriff stehen. Somit wird also durch die Druckflächen 23 eine Anpresskraft auf das Gehäuse 18 ausgeübt, welche Anpresskraft dann auf den Kühlkörper 7 übertragen wird. Es gibt nun grundsätzlich verschiedene Möglichkeiten dafür, an welcher Stelle die Druckflächen 23 an dem Gehäuse 18 angreifen. Bevorzugt ist es, dass die Vielzahl von Druckflächen 23 an dem nichtleitenden Gehäuseabschnitt 19 und/oder an der Grundplattenanordnung 11 oder wie im vorliegenden Ausführungsbeispiel an der Bodenplatte 17 eine Anpresskraft auf das Gehäuse 18 ausüben.

Bezüglich dieser Fixieranordnung 22 kann weiter vorgesehen sein, dass die Fixieranordnung 22 eine Greifanordnung 24 zum Hintergreifen des Gehäuses 18 und eine Hülsenanordnung 25 mit einer Vielzahl von Keramikhülsen 26 aufweist, dass die Vielzahl von Druckflächen 23 von jeweiligen Gehäuseenden 27 der Vielzahl von Keramikhülsen 26 gebildet wird und dass jeweilige Fixierenden 28 der Vielzahl von Keramikhülsen 26 mit der Greifanordnung 24 in Eingriff stehen und gegenüberliegend zum jeweiligen Gehäuseende 27 angeordnet sind. Eine solche Greifanordnung 24 kann beispielsweise aus einem Rahmen oder - gemäß der Darstellung der Fig. 2 und 3 aus Armen einer Klammeranordnung gebildet sein. In beiden Fällen drückt die Greifanordnung 24 das Gehäuse 18 an die Bodenplatte 17. Die Hülsenanordnung 25 kann insbesondere dazu dienen, eine elektrische und auch eine thermische Isolierung zwischen der Greifanordnung 24 - welche etwa zumindest teilweise aus Metall gebildet sein kann - und dem Gehäuse 18 und insbesondere der Bodenplatte 17 bereitzustellen. Grundsätzlich kann die Greifanordnung 24 aber auch aus einem nicht-leitenden Material bestehen.

Die Keramikhülsen 26 können - wie aus der Fig. 2 hervorgeht - an ihrem jeweiligen Gehäuseende 27 und/oder an ihrem jeweiligen Fixierende 28 auch Stifte aufweisen, welche zur Fixierung der Keramikhülsen 26 in Öffnungen der Greifanordnung 24 bzw. des Gehäuses 18 - hier speziell der Bodenplatte 17 - eingeführt sind.

Die obige Beschreibung der Fixieranordnung 22 betrifft hinsichtlich der Befestigung überwiegend das Gehäuse 18 des Elektronikmoduls. Was die andere Seite der Befestigung angeht, nämlich den Kühlkörper 7, ist festzustellen, dass ein solcher keramischer Kühlkörper 7 gegenüber einem Kühlkörper aus Metall auch andere mechanische Eigenschaften aufweist, welche für die Frage der Befestigung mit dem Kühlkörper 7 relevant sind. So ist es z. B. ungünstig, in einen Keramikkörper ein Gewinde hineinzuschneiden. Hier sieht eine bevorzugte und in den Fig. 2 und 3 wiedergegebene Ausführungsform vor, dass die Leistungshalbleiteranordnung 11eine erste Leistungshalbleiterteilanordnung 28a und eine zweite Leistungshalbleiterteilanordnung 28b aufweist, dass die erste Leistungshalbleiterteilanordnung 28a und die zweite Leistungshalbleiterteilanordnung 28b auf jeweils gegenüberliegenden Seiten des Kühlkörpers 7 angeordnet sind, sodass der Kühlkörper 7 die beim Betrieb der ersten Leistungshalbleiterteilanordnung 28a entstehende Wärme durch Wärmeleitung aus einer ersten Richtung 29a und die beim Betrieb der zweiten Leistungshalbleiterteilanordnung 28b entstehende Wärme durch Wärmeleitung aus einer zweiten Richtung 29b aufnimmt und dass die erste Richtung 29a und die zweite Richtung 29b im Wesentlichen entgegengesetzt sind. Entsprechend ist es bevorzugt, dass das Gehäuse 18 einen ersten Gehäuseteil 30a zur Aufnahme der ersten Leistungshalbleiterteilanordnung 28a und einen zweiten Gehäuseteil 30b zur Aufnahme der zweiten Leistungshalbleiterteilanordnung 28b aufweist. In einer Konfiguration gemäß diesem Ausführungsbeispiel kann also grundsätzlich eine Anpresskraft auf den Kühlkörper 7 ausgeübt werden, ohne dass an dem Kühlkörper 7 angegriffen werden muss.

Dies kann insbesondere dadurch verwirklicht werden, dass - wie in den Fig. 2 und 3 gezeigt wird - die Fixieranordnung 22 eine erste Fixiervorrichtung 31a zum Anpressen des ersten Gehäuseteils 30a an den Kühlkörper 7 und eine zweite Fixiervorrichtung 31b zum Anpressen des zweiten Gehäuseteils 30b an den Kühlkörper 7 aufweist. Im Grunde ist also die Fixieranordnung 22 ebenfalls in der Ebene des Kühlkörpers 7 in die erste Fixiervorrichtung 31a und die zweite Fixiervorrichtung 31b aufgeteilt. Entsprechend ist es bevorzugt, dass die erste Fixiervorrichtung 31a einen ersten Teil der Vielzahl von Druckflächen 23 zum Anpressen des ersten Gehäuseteils 30a an den Kühlkörper 7 und die zweite Fixiervorrichtung 31b einen zweiten Teil der Vielzahl von Druckflächen 23 zum Anpressen des zweiten Gehäuseteils 30b an den Kühlkörper 7 aufweist. Damit wird im Ergebnis das Gehäuse 18 von beiden Seiten an den Kühlkörper 7 gepresst. Hierzu ist nur eine Verbindung zwischen den Fixiervorrichtungen 31a, b untereinander erforderlich. Bevorzugt ist, dass zum Anpressen des Gehäuses 18 an den Kühlkörper 7 die erste Fixiervorrichtung 31a mit der zweiten Fixiervorrichtung 31b durch eine kraftschlüssige Verbindung verbunden ist, sodass die Anpresskraft des Gehäuses 18 an den Kühlkörper 7 der Vorspannung der kraftschlüssigen Verbindung entspricht. Diese Verbindung kann auch mittelbar sein und durch eine jeweilige Verbindung der Fixiervorrichtungen 31a, b an ein oder mehrere Zwischenelemente hergestellt werden. Bei der kraftschlüssigen Verbindung kann es sich um eine Verbindung handeln, welche sowohl kraftschlüssig als auch formschlüssig ist. Insbesondere kann es sich - wie aus der Fig. 2 gut zu erkennen ist - um eine Schraubverbindung handeln. Speziell liegt jeweils eine Schraubverbindung der Fixiervorrichtungen 31a, b mit einem Zwischenelement vor. Diese Verbindung zwischen der ersten Fixiervorrichtung 31a und der zweiten Fixiervorrichtung 31b macht also eine entsprechende Verbindung mit dem Kühlkörper 7 entbehrlich, so dass auch kein Gewinde o.dgl. in dem Kühlkörper 7 erforderlich ist.

Wieder zurückkehrend zu der Darstellung der Fig. 1, ist aus dieser zu erkennen, dass eine dort dargestellte Umrichtervorrichtung 38 mit dem obigen Elektronikmodul einerseits mit der Versorgungsleitung 2 elektrisch verbunden ist, andererseits aber auch Anschlüsse im Niederspannungsbereich - also mit einer Betriebsspannung mit einem Effektivwert von weniger als 1 kV - aufweist. Entsprechend ist eine vorschlagsgemäße Umrichtervorrichtung 38 für ein mit elektrischer Energie betriebenes Landfahrzeug 4 dadurch gekennzeichnet, dass die Umrichtervorrichtung 38 ein vorschlagsgemäßes Elektronikmodul, einen hochspannungsseitigen Primäranschluss 32 zur elektrischen Verbindung mit der Versorgungsleitung 2 und zur elektrischen Verbindung mit der Leistungshalbleiteranordnung 1 sowie einen Sekundäranschluss 33 zur elektrischen Verbindung mit einen Niederspannungssystem 34 aufweist. Zwischen dem Primäranschluss und der Leistungshalbleiteranordnung 1 ist regelmäßig noch eine - hier nicht speziell dargestellte - Eingangsbeschaltung zwischengeschaltet. Der Sekundäranschluss kann beispielsweise als Betriebsspannung eine Gleichspannung mit 24 Volt aufweisen. Das Niederspannungssystem 34 weist verschiedene Verbraucher auf, welche mit einer Niederspannung betrieben werden wie etwa eine Klimaanlage, eine Steuerelektronik sowie eine Funkvorrichtung. Bevorzugt ist, dass der Sekundäranschluss 33 von dem Primäranschluss 21 und der Leistungshalbleiteranordnung 1 galvanisch getrennt ist. Auf diese Weise unterliegt die Sekundärseite nicht den strengen Prüfvorschriften der Primärseite.

Bevorzugte Ausgestaltungen der vorschlagsgemäßen Umrichtervorrichtung 38 ergeben sich aus den - bereits beschriebenen oder noch zu beschreibenden - entsprechenden Merkmalen und Ausgestaltungen des vorschlagsgemäßen Elektronikmoduls.

Zur Befestigung an dem Schienenfahrzeug 4a ist bevorzugt vorgesehen, dass das vorschlagsgemäße Elektronikmodul eine Fahrzeugbefestigungsvorrichtung 35 zur Anordnung des Elektronikmoduls an einem Landfahrzeug 4 - vorzugsweise an dem Schienenfahrzeug 4a - aufweist. Dabei bildet das Gehäuse 36 der Umrichtervorrichtung 38, an welcher die Fahrzeugbefestigungsvorrichtung 35 das Elektronikmodul befestigt, und welches elektrisch mit der Karosserie des Landfahrzeugs 4a verbunden ist, ein Massenpotenzial gegenüber der Versorgungsleitung 2 (wenngleich der Betriebsstrom von der Versorgungsleitung 2 durch gesonderte Ableiter fließt). Ggf. ist eine - hier nicht dargestellte - Isolieranordnung zur elektrischen Isolierung des Gehäuses 36 gegenüber insbesondere der Fixieranordnung 22 erforderlich.

Grundsätzlich kann die Leistungshalbleiteranordnung 1 Leistungshalbleiter beliebiger Art, Anzahl und Verschaltung aufweisen. Eine in der Praxis wichtige und insoweit bevorzugte Ausgestaltung, welche auch dem in den Fig. 2 und 3 gezeigten Ausführungsbeispiel entspricht, sieht vor, dass die Leistungshalbleiteranordnung 1 mindestens einen Bipolartransistor mit isolierter Gate-Elektrode (IGBT) 37 zum Betrieb an der elektrischen Versorgungsleitung 2 aufweist. Alternativ oder zusätzlich kann die Leistungshalbleiteranordnung 1 auch mindestens einen Feldeffekttransistor (FET) zum Betrieb an der elektrischen Versorgungsleitung 2 aufweisen. Hier ist es weiter bevorzugt, dass die Leistungshalbleiteranordnung 1 ferner jeweils eine - in der Zeichnung nicht separat gezeigte - Freilaufdiode aufweist. Bezüglich der Sperr- und Isolationsspannung weist der mindestens eine IGBT 37 eine Sperrspannung von 1200 Volt auf. Dies ist - bezogen auf die oben beschriebene Betriebsspannung von 1500 Volt der Versorgungsleitung 2 - ein üblicher Wert. Denkbar ist auch eine Sperrspannung von beispielsweise 1700 Volt. Durch den Kühlkörper 7 aus dem Keramikmaterial beträgt hier die Isolationsspannung - und zwar von der obigen Kontaktanordnung 20 zu dem Massepotenzial - mindestens 5900 Volt. Hingegen üblich bei Standardmodulen von IGBTs 37 mit einer Sperrspannung von 1200 Volt sind Isolationsspannungen von lediglich 2500 bis 4000 Volt zwischen der Kontaktanordnung 20 und der Bodenplatte 17. Auf diese Weise wird also ein Elektronikmodul erhalten, welches bezüglich des Verhältnisses von Sperr- zu Isolationsspannung flexibler ausgelegt werden kann. Durch eine z.B. Reihenschaltung von Leistungshalbleitern innerhalb einer Leistungshalbleiteranordnung 1 oder durch eine Reihenschaltung von Modulen mit jeweils eigenen Leistungshalbleiteranordnungen 1 kann sich für diese Reihenschaltung bzw. für die sie umfassende Schaltanordnung insgesamt auch eine dann entsprechend höhere Sperrspannung ergeben.

Eine bevorzugte Ausgestaltung der vorschlagsgemäßen Umrichtervorrichtung 38 ist dadurch gekennzeichnet, dass die Umrichtervorrichtung 38 einen Hilfsbetriebeumrichter zur elektrischen Energieversorgung von Nebenaggregaten des mit elektrischer Energie betriebenen Landfahrzeugs 4 bildet. Diese Variante ist in der Fig. 1 dargestellt. Hier ist bevorzugt, dass die Umrichtervorrichtung 38 zum Umrichten der Betriebs-Hochspannung der Versorgungsleitung 2 in eine Betriebs-Niederspannung für den Hilfsbetrieb angeordnet ist.

## Patentansprüche

1. Elektronikmodul mit einer Leistungshalbleiteranordnung (1), welche Leistungshalbleiteranordnung (1) zum Betrieb an einer elektrischen Versorgungsleitung (2), welche mit einer Betriebs-Hochspannung gespeist wird, einer Netzinfrastruktur (3) zum leitungsgebundenen Betrieb von Landfahrzeugen (4) eingerichtet ist, wobei das Elektronikmodul einen Kühlkörper (7) zur Aufnahme von beim Betrieb der Leistungshalbleiteranordnung (1) entstehender Wärme durch Wärmeleitung aufweist und wobei der Kühlkörper (7) dazu eingerichtet ist, die aufgenommene Wärme überwiegend durch Wärmeströmung an Fluid abzugeben, **dadurch gekennzeichnet, dass** der Kühlkörper (7) aus einem Keramikmaterial besteht.

2. Elektronikmodul nach Anspruch 1, **dadurch gekennzeichnet, dass** das Elektronikmodul eine Zuführvorrichtung (8) zum Zuführen eines Kühlfluids (9), vorzugsweise einer Kühlflüssigkeit (9a), an den Kühlkörper (7) und zum Abführen des Kühlfluids (9) von dem Kühlkörper (7) und eine Leitungsanordnung (10) zum Durchleiten des Kühlfluids (9) durch den Kühlkörper (7) aufweist, sodass von dem Kühlkörper (7) aufgenommene Wärme an das zugeführte Kühlfluid (9) abgegeben und das somit erwärmte Kühlfluid (9) von der Zuführvorrichtung (8) abgeführt wird.

3. Elektronikmodul nach Anspruch 1 oder 2, **dadurch gekennzeichnet, dass** das Elektronikmodul eine zwischen der Leistungshalbleiteranordnung (1) und dem Kühlkörper (7) angeordnete Grundplattenanordnung (11) aufweist, sodass die beim Betrieb der Leistungshalbleiteranordnung (1) entstehende Wärme durch Wärmeleitung mittels der Grundplattenanordnung (11) an den Kühlkörper (7) übertragen wird.

4. Elektronikmodul nach Anspruch 3, **dadurch gekennzeichnet, dass** eine Deckfläche (12) des Kühlkörpers (7) eine zu der Deckfläche (12) im Wesentlichen parallele und der Deckfläche (12) zugewandte Grundfläche (13) der Grundplattenanordnung (11) im Wesentlichen vollständig abdeckt, vorzugsweise, dass die Deckfläche (12) die Grundfläche (13) im Wesentlichen entlang des gesamten Umrisses der Grundfläche (13) überragt, insbesondere, dass auf der Deckfläche (12) eine vorzugsweise metallische Leiterschichtfläche (14) angeordnet ist, weiter vorzugsweise, dass die Leiterschichtfläche (14) die Grundfläche (13) im Wesentlichen vollständig abdeckt.

5. Elektronikmodul nach Anspruch 3 oder 4, **dadurch gekennzeichnet, dass** die Grundplattenanordnung (11) eine ebene Trägerplatte (15) aufweist, auf welcher die Leistungshalbleiteranordnung (1) befestigt ist, und dass das Elektronikmodul eine auf die Trägerplatte (15) aufgetragene Leiterbahnanordnung (16) zur elektrischen Verbindung der Leistungshalbleiteranordnung (1) aufweist, vorzugsweise, dass die Trägerplatte (15) eine Keramikplatte ist und die Leiterbahnanordnung (16) Kupferleiterbahnen umfasst.

6. Elektronikmodul nach einem der Ansprüche 3 bis 5, **dadurch gekennzeichnet, dass** die Grundplattenanordnung (11) eine metallische und ebene Bodenplatte (17), vorzugsweise umfassend Kupfer, aufweist, weiter vorzugsweise, welche gegenüber der Leistungshalbleiteranordnung (1) elektrisch isoliert ist, insbesondere, dass die Bodenplatte (17) die Trägerplatte (15) im Wesentlichen vollständig abdeckt, weiter insbesondere, dass die Bodenplatte (17) mit der Leiterschichtfläche (14) elektrisch verbunden ist, sodass die Leiterschichtfläche (14) gegenüber der Bodenplatte (17) auf einem im Wesentlichen identischen elektrischen Potenzial ist.

7. Elektronikmodul nach einem der Ansprüche 1 bis 6, **dadurch gekennzeichnet, dass** das Elektronikmodul ein Gehäuse (18), vorzugsweise umfassend die Grundplattenanordnung (11), zur Aufnahme der Leistungshalbleiteranordnung (1) aufweist, vorzugsweise, dass das Gehäuse (18) einen nichtleitenden Gehäuseabschnitt (19) aufweist, dass das Elektronikmodul eine Kontaktanordnung (20) an dem nichtleitenden Gehäuseabschnitt (19) zur elektrischen Verbindung mit Polen (21) der Leistungshalbleiteranordnung (1) aufweist, insbesondere, dass die Kontaktanordnung (20) gegenüber der Bodenplatte (17) elektrisch isoliert ist.

8. Elektronikmodul nach Anspruch 7, **dadurch gekennzeichnet, dass** das Elektronikmodul eine Fixieranordnung (22) zum Anpressen des Gehäuses (18) an den Kühlkörper (7) aufweist, vorzugsweise, dass die Fixieranordnung (22) eine Vielzahl von Druckflächen (23) zum Anpressen des Gehäuses (18) an den Kühlkörper (7) aufweist, welche jeweils beabstandet voneinander mit dem Gehäuse (18) im Eingriff stehen, insbesondere, dass die Vielzahl von Druckflächen (23) an dem nichtleitenden Gehäuseabschnitt (19) und/oder an der Grundplattenanordnung (11), weiter insbesondere an der Bodenplatte (17), eine Anpresskraft auf das Gehäuse (18) ausüben.

9. Elektronikmodul nach Anspruch 8, **dadurch gekennzeichnet, dass** die Fixieranordnung (22) eine Greifanordnung (24) zum Hintergreifen des Gehäuses (18) und eine Hülsenanordnung (25) mit einer Vielzahl von Keramikhülsen (26) aufweist, dass die Vielzahl von Druckflächen (23) von jeweiligen Gehäuseenden (27) der Vielzahl von Keramikhülsen (26) gebildet wird und dass jeweilige Fixierenden (28) der Vielzahl von Keramikhülsen (26) mit der Greifanordnung (24) in Eingriff stehen und gegenüberliegend zum jeweiligen Gehäuseende (27) angeordnet sind.

10. Elektronikmodul nach einem der Ansprüche 1 bis 9, **dadurch gekennzeichnet, dass** die Leistungshalbleiteranordnung (11) eine erste Leistungshalbleiterteilanordnung (28a) und eine zweite Leistungshalbleiterteilanordnung (28b) aufweist, dass die erste Leistungshalbleiterteilanordnung (28a) und die zweite Leistungshalbleiterteilanordnung (28b) auf jeweils gegenüberliegenden Seiten des Kühlkörpers (7) angeordnet sind, sodass der Kühlkörper (7) die beim Betrieb der ersten Leistungshalbleiterteilanordnung (28a) entstehende Wärme durch Wärmeleitung aus einer ersten Richtung (29a) und die beim Betrieb der zweiten Leistungshalbleiterteilanordnung (28b) entstehende Wärme durch Wärmeleitung aus einer zweiten Richtung (29b) aufnimmt und dass die erste Richtung (29a) und die zweite Richtung (29b) im Wesentlichen entgegengesetzt sind, vorzugsweise, dass das Gehäuse (18) einen ersten Gehäuseteil (30a) zur Aufnahme der ersten Leistungshalbleiterteilanordnung (28a) und einen zweiten Gehäuseteil (30b) zur Aufnahme der zweiten Leistungshalbleiterteilanordnung (28b) aufweist.

11. Elektronikmodul nach Anspruch 10, **dadurch gekennzeichnet, dass** die Fixieranordnung (22) eine erste Fixiervorrichtung (31a) zum Anpressen des ersten Gehäuseteils (30a) an den Kühlkörper (7) und eine zweite Fixiervorrichtung (31b) zum Anpressen des zweiten Gehäuseteils (30b) an den Kühlkörper (7) aufweist, vorzugsweise, dass die erste Fixiervorrichtung (31a) einen ersten Teil der Vielzahl von Druckflächen (23) zum Anpressen des ersten Gehäuseteils (30a) an den Kühlkörper (7) und die zweite Fixiervorrichtung (31b) einen zweiten Teil der Vielzahl von Druckflächen (23) zum Anpressen des zweiten Gehäuseteils (30b) an den Kühlkörper (7) aufweist, insbesondere, dass zum Anpressen des Gehäuses (18) an den Kühlkörper (7) die erste Fixiervorrichtung (31a) mit der zweiten Fixiervorrichtung (31b) durch eine kraftschlüssige Verbindung verbunden ist, sodass die Anpresskraft des Gehäuses (18) an den Kühlkörper (7) der Vorspannung der kraftschlüssigen Verbindung entspricht.

12. Elektronikmodul nach einem der Ansprüche 1 bis 11, **dadurch gekennzeichnet, dass** das Elektronikmodul eine Fahrzeugbefestigungsvorrichtung (35) zur Anordnung des Elektronikmoduls an einem Landfahrzeug (4), vorzugsweise an einem Schienenfahrzeug (4a), aufweist.

13. Elektronikmodul nach einem der Ansprüche 1 bis 12, **dadurch gekennzeichnet, dass** die Leistungshalbleiteranordnung (1) mindestens einen Bipolartransistor mit isolierter Gate-Elektrode (IGBT) (37) zum Betrieb an der elektrischen Versorgungsleitung (2), vorzugsweise mit jeweils einer Freilaufdiode, aufweist.

14. Umrichtervorrichtung (38) für ein mit elektrischer Energie betriebenes Landfahrzeug (4), **dadurch gekennzeichnet, dass** die Umrichtervorrichtung (38) ein Elektronikmodul nach einem der Ansprüche 1 bis 13, einen hochspannungsseitigen Primäranschluss (32) zur elektrischen Verbindung mit der Versorgungsleitung (2) und zur elektrischen Verbindung mit der Leistungshalbleiteranordnung (1) sowie einen, vorzugsweise von dem Primäranschluss (32) und der Leistungshalbleiteranordnung (1) galvanisch getrennten, Sekundäranschluss (33) zur elektrischen Verbindung mit einen Niederspannungssystem (34) aufweist, insbesondere, dass die Umrichtervorrichtung 38 einen Transformator (39) mit einer Primärwicklung auf Seiten des Primäranschlusses (32) und eine Sekundärwicklung auf Seiten des Sekundäranschlusses (33) aufweist.

15. Umrichtervorrichtung (38) nach Anspruch 14, **dadurch gekennzeichnet, dass** die Umrichtervorrichtung (38) einen Hilfsbetriebeumrichter zur elektrischen Energieversorgung von Nebenaggregaten des mit elektrischer Energie betriebenen Landfahrzeugs (4) bildet und dass die Umrichtervorrichtung zum Umrichten der Betriebs-Hochspannung der Versorgungsleitung (2) in eine Betriebs-Niederspannung für den Hilfsbetrieb angeordnet ist.
